# EUROPEAN PATENT APPLICATION

(11) **EP 1 892 319 A1**
(43) Date of publication of application: **27.02.2008**
(21) Application number: 06300891.6
(22) Date of filing: 24.08.2006
(51) Int. Cl.: C23C 18/02

(54) **Dip-coating unit for continuous coating of elongated substrates**

(71) Applicant: Nexans, 75008 Paris (FR)
(72) Inventor: Isfort, Dirk, 50937 Köln (DE); Ehrenberg, Jürgen, 50354 Hürth (DE)
(74) Representative: Feray, Valérie

(57) **Abstract**

The present invention relates to a device and a process for preparing simultaneously double-sided coated substrates of long length (4) in continuous manner by wet chemical processes such as MOD wherein for the simultaneous deposition of the layers on both sides of the substrate of long length (4) a dip-coating unit is used with vertical set-up of the coating container (1) and e. g. the furnace (2).

## Description

The present invention relates to a device for double-sided coating of an article of long length such as tapes or wires wherein simultaneously both the front and rear side of the article is provided with a coating in a continuous manner.
In particular, the present invention is useful for double-sided coating of substrates for coated conductors.

Typically, coated conductors comprise a metallic or ceramic substrate, at least one buffer layer and a superconducting layer.

Though not restricted thereto nowadays the rare earth barium cuprate type superconductors of the formula REBa₂Cu₃O₇₋ₓ are commonly used for coated conductors. A particular member thereof is that one known by the reference YBCO-123 wherein the numerical combination 123 stand for the stoichiometric ratio of the elements Y, Ba and Cu.

Usually, the buffer layers are oxides and include e. g. cerium oxide, yttrium stabilized zirconia (YSZ), strontium titanium oxide and various rare earth oxides.

One major problem in the production of such high temperature superconductors is the orientation or alignment of the crystal grains of the superconductor material which should be as high as possible in order to have high current carrying properties. In the desired highly aligned superconductor layers the crystal grains should be well aligned at least in a, b-direction parallel to the plane of the substrate. In addition, there should be also good alignment in c-direction perpendicular to the plane of the substrate. A further problem is achieving highly aligned substrates and/or highly aligned buffer layers onto which the superconductor can be grown in the desired orientation.

There are several methods for achieving the desired highly aligned texture.
According to one method the high temperature supercondcutor is deposited on a single crystalline substrate of suitable orientation. However, single crystalline substrates are generally expensive and have only poor mechanical properties. Further, the surface area is only limited so that large scale production of coated conductors with long length as required in the application of cables and windings is not possible.
According to another approach on randomly oriented metallic substrates a highly textured buffer layer is deposited which serves to transfer the desired texture to the superconductor layer grown on the buffer layer. This method is called IBAD (ion beam assisted deposition).
IBAD relates to a vacuum deposition technique requiring specific equipment.
Further, by such vacuum techniques coating of substrates of long length is difficult and long deposition times are required.

According to yet another approach highly textured substrates are used which are obtainable by mechanical working. This method is called RABiTs (rolling assisted biaxial texturing of substrates).
On such textured substrates as obtained by RABiTs buffer layers with suitable texture can be deposited which, in turn, can serve as template for transferring the desired texture to a superconductor layer to be grown on the buffer layer.

For deposition of the buffer layer and/or superconductor layer wet chemical processes can be applied. Wet chemical processes are non vacuum techniques and are, thus, within the focus of the present invention.

Generally, in wet chemical processes a suitable precursor of the material which shall be prepared is solved in a solvent to prepare a precursor solution also referred to "coating solution" in the following. The precursor solution is deposited on the substrate and the formed fresh (green) layer is converted to the desired material by subsequent heat-treating.

For the preparation of oxide high temperature superconductors such as the rare earth cuprates as referred to above typically organic compounds of the metals are used as precursor materials, such as the acetates, β-diketonates and alkoxides of the respective metal.

During the subsequent heat-treatment the metal organic compounds are converted to the respective oxides.

This process using organic compounds of the metals as precursors is generally referred to metal organic deposition/decomposition (MOD).
Depending on the precursor materials used and/or solvents etc. there are different techniques in the metal organic deposition such as the sol-gel technique etc.

There are also known different techniques for depositing the precursor solution on the substrate dip-coating being one of them.
Here the substrate is immersed into the precursor solution and the green yet unhardened layer is transferred to the furnace for heating in order to remove residual solvent and converting the precursor material to the final material, for example in the preparation of coated conductors to the desired oxides.

For dip-coating of substrates of long length such as tapes or wires conventionally a so-called reel-to-reel dip-coating unit is used. The reel-to-reel dip-coating unit includes a pay-out roller, a solution container with the precursor solution, guide rollers and a take-up roller. Downstream to the solution container a furnace can be arranged. The pay-out roller provides the substrate for dipping into the solution container. The guide rollers serves to direct the substrate into the precursor solution and to the furnace.

The arrangement of the equipment and the passing direction of the substrate is essentially in horizontal direction. On moving the freshly coated substrate to the furnace and take-up roller, respectively, the substrate is guided at least over one guide roller. That is, at least on side of the substrate comes into direct contact with the surface of the guide roller. However, since the fresh yet unhardened layer is very sensitive to mechanical stress any contact with hard surfaces such as the surface of the guide roller can cause defects. Further it has been observed that part of the fresh layer adheres to the surface of guide roller or the like and remains stuck so that the layer becomes damaged.

In the consequence, it is not possible to obtain high quality final layers on said side of the tape or wire in contact with the guide roller or any other surface.
However, to be suitable for coated conductors defect free high quality layers are required, e. g. in case of the superconductor layer in view of the superconducting properties and, respectively, in case of the buffer layer to allow undisturbed growth of the superconductor layer thereon.

A further problem associated with conventional dip-coating units as referred to above in the preparation of coated conductors is the stability of the solution.
For continuous long term operation of the dip-coating unit large volumes of the precursor solution are required, usually more than 50 to 100 ml.

Due to the large volume of the precursor solution the exchange rate of the precursor solution, that is the replacement of precursor solution by fresh solution, in conventional dip-coating units is only low, usually a few days.

For ensuring homogenous and uniform layer formation the precursor solution must be constant throughout the operation time. However, due to evaporation of the organic solvent used for solving the precursor the precursor concentration within the solution increases with time. Consequently, the properties of the resulting film, in particular film thickness, changes over time which is undesired.

On the other side, adjusting the concentration of the precursor solution by, for example, admixing further solvent, is problematically since for homogenous distribution of the additional solvent stirring or the like is necessary. However, any convection caused in the solution by stirring or the like might lead to inhomogeneities in the thickness of the film.

There exist numerous publications dealing with the coating of substrates with high temperatures superconductor films and/or providing films on a substrate via dip-coating.

For example, in JP 704 13 75 of Ogiwara Takashi et al. a dip-coating unit and a process for formation of ceramic thin film is disclosed. The unit of JP 704 13 75 is arranged in vertical manner with a coating container and a furnace wherein the furnace is placed above the coating container. Further, a pre-drying zone is provided between the furnace and the coating container. In operation the substrate, which is fixed to a fiber is immersed into the coating solution and then pulled-up from the solution through the drying zone and the furnace by a winding roller on which the fiber is wound. However the unit and the process are directed to the discontinuous coating of an individual workpiece rather than to the simultaneous double-sided coating of a substrate of long length in a continuous manner.
Furthermore, since the coating container with the coating solution is open towards the pre-drying zone and the furnace evaporated material of the coating solution can come into contact with the heated surfaces of the pre-drying zone and the furnace and can cause contamination of both the heaters and the fresh coating formed on the substrate.

DE 42 34 590 C1 relates to the double-sided simultaneous coating of a substrate with high temperature superconductor film.
Coating is carried out by sputtering, that is a vacuum based technique. Further, as substrates individual workpieces are used rather than long length substrates such as wires or tapes.

There are also known automatic systems for dip-coating substrates including a transport system, one ore more coating bathes and a drying oven arranged one after the other in horizontal manner wherein the substrate is transported by the transport system to the at least one coating bath, immersed therein, raised-out of the bath and, eventually, delivered to the next bath and finally to the drying oven (see for example WO 02/071502 A3; US-Patent 5,334,246).
The substrates addressed here are individual workpieces. That is, by these automatic systems a plurality of individual workpieces can be coated one after the other but there is no indication as to the continuous coating of a substrate of long length.

In view of the above the present invention relates to the coating of a substrate of long length such as a tape or wire or the like, simultaneously on both sides of the substrate in a continuous manner with a layer or film which is defect free and homogenous even in long term operation of the coating unit.
In particular, the present invention relates to the preparation of double-sided coated coated conductors of long length wherein coating can be carried out by a non-vacuum technique.

According to the present invention these objects are solved by a dip-coating unit for simultaneous double-sided coating of a substrate of long length in continuous manner which comprises a solution container, a furnace, at least one supply means for delivering the substrate of long length and at least one pulling means for pulling the substrate of long length continuously through the solution container and the furnace, and, optionally, a pre-drying zone wherein the furnace or, if a pre-drying zone is provided, at least the pre-drying zone is arranged in vertical set-up relative to the solution container.

Further, the present invention is directed to a process for the preparation of a double-sided coated substrate of long length, in particular of a double-sided coated conductor, wherein the substrate of long length is simultaneously coated on both sides with at least one layer by passing the substrate of long length through a coating solution comprising a precursor material for the layer to be formed and forwarding the freshly coated substrate of long length to a furnace for converting the fresh coating to the final material, wherein the freshly coated substrate of long length is passed in vertical set-up until the freshly deposited layers on both sides are at least pre-hardened.

The present invention relates also to a double-sided coated conductor wherein a substrate of long length comprises on both the front and rear side one or more equal layers wherein the equal layers on the front and rear side are obtainable by simultaneous deposition by metal organic deposition (MOD).

"Vertical set-up" means that the drawing direction of the freshly coated substrate is essentially vertical until the freshly deposited layer is at least hardened to an extent that the layer can withstand contact with hard surfaces without damage.
Thus, according to the present invention any contact of the freshly deposited yet unhardened layers on the substrate of long length with a surface that could cause any damage of the freshly deposited yet unhardened layer can be avoided by passing the freshly deposited substrate of long length in vertical direction until sufficient hardening, for example in a pre-drying step.

According to the present invention the term "substrate of long length" relates to long substrates such as tapes and wires having a long length extension along one axis contrary to individual workpieces.

According to the present invention the term "coating in continuous manner" relates to a process, wherein a substrate of long length is continuously drawn through the coating solution contrary to the coating of individual workpieces which are individually immersed into the coating solution and raised out of the coating solution.

According to the present invention the term "simultaneous double-sided coating" means that on the both sides with long extension, usually the rear and front side, of a substrate of long length simultaneously a layer is deposited.

According to the present invention it is possible to obtain layers of equally high quality on both sides of a substrate of long length simultaneously by dip-coating.

That is, the present invention provides a cost-efficient and simple technique for obtaining such double-sided coated substrates, in particular useful for coated conductors.

Since according to the present invention the dip-coating unit has a vertical set-up guide rollers can be avoided between the coating container and the furnace and the pre-drying zone, respectively for guiding and supporting the substrate of long length and the substrate of long length with the freshly deposited layers on both sides is pulled essentially in vertical direction out from the coating container to the furnace and through the furnace.

Generally, the present dip-coating unit with vertical arrangement can be advantageously used for providing substrates of long length with layers of any material by dip-coating process in continuous manner.

The present invention is particularly useful in the production of double-sided coated conductors for depositing buffer layers as well as the high temperature superconductor layers on a substrate of long length.

In particular, the present invention is advantageously useful in the production of coated conductors using textured substrates such as obtainable by RABiTs method wherein the buffer layers and/or high temperature superconductor layer is deposited by non-vacuum technique.

In particular, the present invention is advantageously useful in the production of double-sided coated conductors wherein the buffer layers and/or high temperature superconductor layers are deposited by MOD techniques, for example sol-gel technique such as the trifluoroacetate route using the metal trifluoroacetates as precursors.

In the production of coated conductors according to the present invention in principle any oxide superconductor can be used such as the rare earth barium cuprate type superconductor referred to above, the bismuth-strontium-calcium-cuprate type superconductor known by the reference BSCCO-2212 and BSCCO-2223 or one of TI or Hg superconductors for example thallium-strontium-calcium-barium-cuprate type superconductors and mercury-barium-strontium-calcium-cuprate type superconductors, respectively. A preferred superconductor material is REBCO-123 with RE being rare earth metal, in particular YBCO-123.

For the preparation of the double-sided coated conductor according to the present invention generally any MOD method can be used.
As set out above examples of organic compounds of the metal suitable as precursors are the carboxylates such as the acetates, β-diketonates and alkoxides.
Depending on the nature of the particular metal organic compound suitable solvants are alcohols, water, acetone, carboxylic acids such as acetic acid.

An example of a preferred MOD method is the so called sol-gel technique, in particular the trifluoroacetate route making use of metal trifluoroacetates as precursors which can be solved in alcohols, e. g. methanol.

Preparation of oxide high temperature superconductor layers and buffer layers via sol-gel technique, in particular the TFA route, are well known in the art and reference is made to this respect to Gupta A. et al. "Superconducting oxide films with high transition temperature prepared from metal trifluoroacetate precursors" in Appl. Phys. Lett. 52 (24) June 13th, 1988, pages 2077 to 2079 and to McIntyre Paul C. et al. "Metalorganic deposition of high-Jc Ba2YCu3O7 - x thin films from trifluoroacetate precursors onto (100) SrTiO3" in J. Appl. Phys. 68 (8) October 15th, 1990, pages 4183 to 4187).

Suitable examples of textured substrates for the present invention are those obtainable by RABiTs wherein metallic tapes are provided with the desired texture by roll texturing. Examples for metal substrates are Ni, Ag or Ni alloys.

According to the present invention double-sided coated conductors can be obtained by a non-vacuum technique such as metal organic deposition, wherein the layers deposited simultaneously on the front and rear side of the substrate have equally high quality and are essentially defect free.

Since both the layers deposited on the front side as well as that deposited simultaneously on the rear side are of equal high quality both layers are suitable as layers in coated conductors allowing the production of double-sided coated conductors with equal properties on both sides by a cost efficient and simple method.

Since in the double-sided coated conductor of the present invention the equal layers on the front and rear side of the substrate of long length are deposited simultaneously they are essentially identical in nature such as composition, structure etc..

Layers obtained by MOD such as sol-gel technique can be easily identified and distinguished over layers obtained by other techniques such as by vacuum techniques in view of micro-structure such as for example grain size, porosity, defect type and density using, for example, transmission electron microscopy (TEM) which is standard for coated conductors.
Insofar the coated conductors according to the present invention can be easily distinguished over coated conductors obtained by vacuum-based techniques.

In the following the present invention is explained in more detail by reference to the accompanying figures. These figures are more or less schematically and serve for a better illustration of the specific arrangements shown.

It is shown
- in figure 1 a: conventional arrangement of a dip-coating unit;
- in figures 2 a and 2 b: embodiments of arrangements of a dip-coating unit according to the present invention;
- in figure 3: a further embodiment of a dip-coating unit according to the present invention with a pre-drying zone;
- in figure 4: preferred embodiment of a dip-coating unit of the present invention;
- in figure 5: an enlarged section of the unit shown in figure 4;
- in figures 6 a and 6 b: examples of architectures for double-sided coated conductors; and
- in figures 7a and 7 b: diagrams of suitable temperature profiles for the pre-drying zone and the furnace in the production of coated conductors.

In the following reference is made to the substrate of long length as "substrate tape".

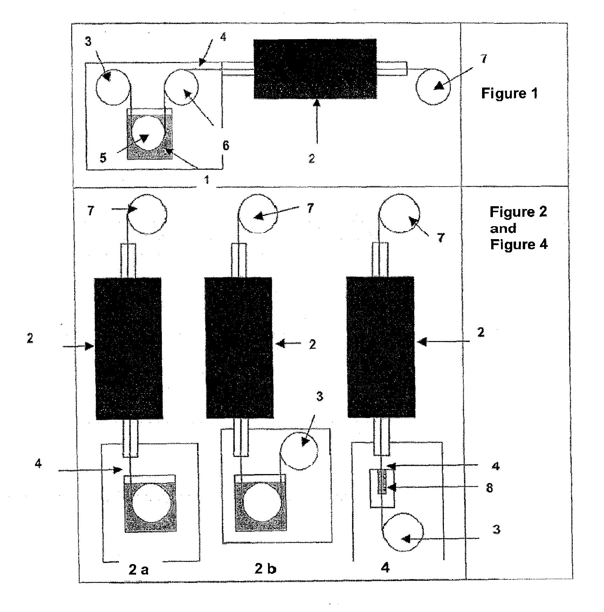

In figure 1 schematically an conventional dip-coating unit with horizontal arrangement is shown.
"Horizontal arrangement" means that the substrate tape 4 is guided essentially in horizontal direction through the solution container 1 and the furnace 2. The unit as shown in figure 1 is provided with a pay-out roller 3 for feeding the substrate tape 4 to the solution container 1, guiding rollers 5 and 6 for guiding and supporting the substrate tape 4 and a take-up roller 6 for receiving and winding up the finished coated substrate tape 4.

For coating the substrate tape with the coating solution the tape 4 is drawn continuously through the coating solution within the solution container 1. By drawing the tape 4 through the coating solution, in principle, both the front and rear side of the tape 4 are coated with the coating solution.

However, the green (unfired) precursor layers formed on drawing the tape 4 through the coating solution are soft and liable to mechanical damage. Thus, if a side of the tape 4 with the green unfired precursor layer comes in direct contact with a hard surface, such as the surface of a guide roller, here guide roller 6, the green yet unhardened layer is subjected to mechanical stress and pressure causing defects in the layer. If such defective green layer is fired to be hardened and converted to the final material by subsequent heat treatment only defective final layers are obtained of minor quality. Such defective layers are not suited for coated conductors requiring high quality layers.

Since in the conventional dip-coating unit with horizontal arrangement a guide roller 6 is required for supporting and guiding the freshly coated substrate tape 4 on its way from the solution container 1 to the furnace 2 in such arrangement inevitably one side of the substrate tape 4 with the fresh unfired layer comes into contact with the surface of guide roller 6. Due to this unavoidable contact defects are caused in the fresh layer on this side making impossible to obtain a final layer of high quality.
Consequently with conventional dip-coating units it is not possible to obtain on both sides of a substrate tape equally high quality layers.

In figures 2 a and 2 b schematically embodiments of a dip-coating unit of the present invention are shown. As is shown in figures 2 a and 2 b in the unit of the present invention the solution container 1 and the furnace 2 are arranged in a vertical set-up. Due to the vertical set-up no guide roller is required between the solution container 1 and the furnace 2. Thus, according to the present invention none of the sides of the freshly coated substrate tape 4 comes into contact with any hard surface which could damage the green yet unhardened film.

For transportation of the substrate tape 4 pulling means are provided, which are usually arranged downstream to the furnace 2. For pulling a take-up roller 7 can be provided.

Further for delivery the substrate tape 4 to the solution container 1 supply means can be provided, e. g. a pay-out roller 3.

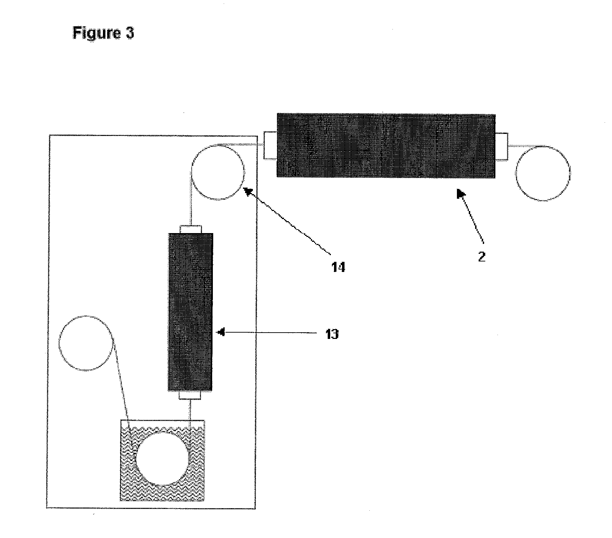

According to a further embodiment as shown in figure 3 the dip-coating unit of the present invention can comprise a pre-drying zone 13 between coating container 1 and furnace 2.
In the pre-drying zone the freshly deposited green layer is pre-hardened at elevated temperature, however, yet not converted to the final material.
Due to this pre-hardening step the risk of damage of the layer by mechanical impact is reduced which facilitates further processing.
That is, when pre-hardened the risk of damage by contact with hard surfaces is essentially minimized. Consequently for further moving the substrate of long length e. g. to furnace 2 for final heat treatment, according to need, contact with surfaces such as of guide rollers 14 is now possible without the risk of damage.

According to the present invention any suitable pre-drying means such as drying oven etc. can be used for the pre-drying zone.

Due to the vertical set-up of the present dip-coating unit it is possible to obtain simultaneously in one and the same process step on both sides of the substrate tape 4 final layers of equally high quality.

Preferably a barrier or similar means can be provided for closing the solution container 1 toward its environment. By such barrier evaporated material of the coating solution is prevented to come into contact with the heater surface and the part of the substrate tape in the heated area of the heaters in the pre-drying zone 13 and/or furnace 2 which could cause undesired deposition of precursor fragments such as carbon etc.

For providing such barrier according to the present invention the coating solution can be contained in a tank which is closed towards its environment. Further, it is also possible to house the solution container 1 in a housing shielding the solution container 1 towards the furnace 2.

As is clear any other constructional means suitable to prevent evaporated precursor solution to reach the heated area of the furnace and pre-drying zone, respectively, is likewise applicable.

Since the aperture which has to be provided in any tank or housing in order to allow the freshly coated substrate to pass towards the furnace 2 can be only small possible passage of any evaporated material of the coating solution is usually negligible only.

Further, some over-pressure can be applied to the space outside the barrier separating the solution container for avoiding entering of any evaporated material.

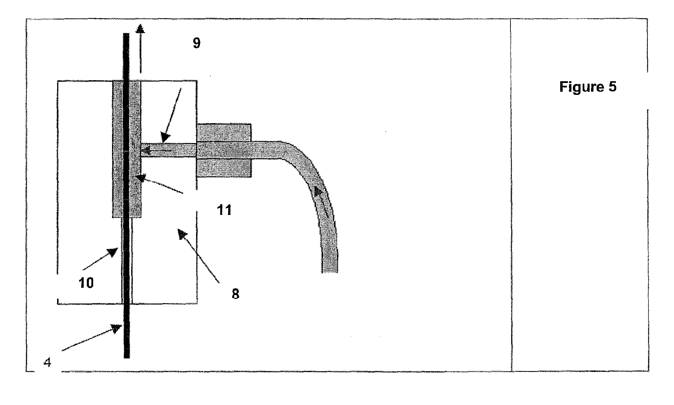

A further embodiment of a dip-coating unit of the present invention is shown in figure 4 wherein the solution container 1 is designed as a coating nozzle 8.
As shown in figure 4 the coating nozzle 8 has a vertical slit 9 in its interior which extends from the bottom to the top of the nozzle 8 for passage of the substrate tape 4. That is, in this embodiment the substrate tape 4 is passed through the coating nozzle in vertical manner, too.

The slit 9 at least comprises two parts of different width arranged one after the other in vertical manner with a lower part 10 having a width which is only some microns larger than the thickness of the substrate tape 4 and an upper part 11 with a larger width containing the coating solution.
As shown in figure 4 the substrate tape 4 to be coated is fed via the lower slit part 10 and passed through the upper part 11 with the coating solution.

An enlarged illustration of the coating nozzle 8 is shown in figure 5.

Connected to the upper slit part 11 is a supply pipe 12 for supplying the coating solution.

Via the supply pipe 12 coating solution can be continuously supplied to the upper slit part 11. Since the volume of the coating solution within the upper slit part 11 can be only small the exchange rate can be high. For example, in the production of coated conductors the volume in the upper slit part 11 can be selected generally to be 1 ml or less resulting in an exchange rate of only a few hours.

As is clear the dimensions of the lower and upper slit part 10 and 11 generally depend on the dimensions of the substrate tape 4 such as thickness, width etc..

For example, in case of a substrate tape 4 with 10 mm width it would be sufficient to design the upper slit part 11 to be about 20 mm in height and 5 mm and 12 mm, respectively, in the lateral directions.

Since the supply rate of fresh solution can be kept low influences of any convection on the homogeneity of the freshly formed layer can be avoided. In addition, on constant feeding of the precursor in the coating solution the concentration of the coating solution can reach an equilibriums state.
This arrangement allows continuous precursor renewal within the coating nozzle 8, and, thus, a process with improved stability resulting in homogeneous and uniform properties in terms of layer thickness etc. even during long term coating operation.

As set out above, the width of the lower slit part 10 is usually selected such to just allow the passage of the tape. That is, usually the width is only marginally wider than the width or cross-sectional extension of the substrate.
Thus, depending on the surface tension of the coating solution leakage of the coating solution from the upper slit part 11 through the lower slit part 10 may be prevented by the surface tension of the coating solution itself.

However, usually the surface tension of the metal organic solution used for MOD, in particular for sol-gel technique, is very low. Thus, for preventing leakage the lower slit part 10 should be made or lined with a material of low surface energy such as teflon, teflon coated steel etc..

It is also possible, to provide only the junction of the lower slit part 10 with the upper slit part 11 with such material of low surface energy.

In the embodiment of figure 4 the supply pipe 12 is vertically connected to the upper slit part 11. However, as is clear, the connection is not restricted to such vertical connection but can be carried out in any manner suitable for supply of the coating solution to the coating nozzle 8.

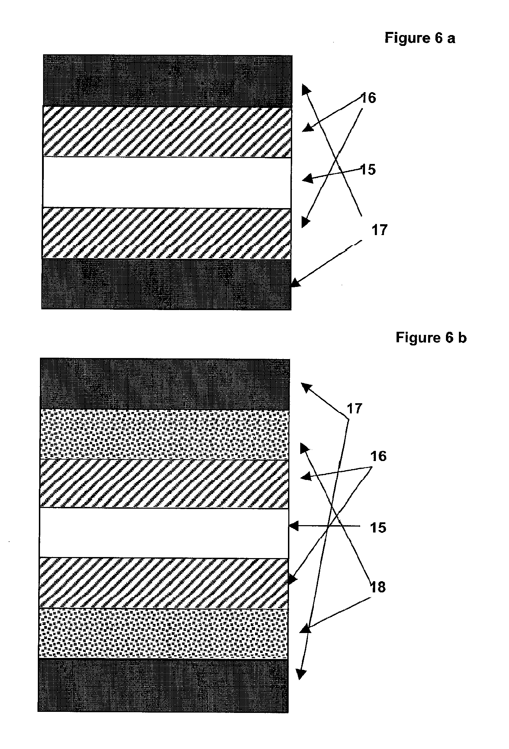

In figures 6 a and 6 b cross-sectional views of suitable architectures for double-sided coated conductors obtainable according to the present invention are shown.
The double-sided coated conductors as shown in figure 6 a and 6 b comprise a substrate 15 and on each the front and rear side at least a buffer layer 16 and a superconductor layer 17.
In the architecture shown in figure 6 b a second buffer layer 18 is comprised.

Typical thickness for these layers in nowadays coated conductors are from about 25 µm to about 150 µm for the substrate, from about 50 nm to about 2500 nm for the buffer layers and from about 500 nm to about 5000 nm for the superconductor layers.

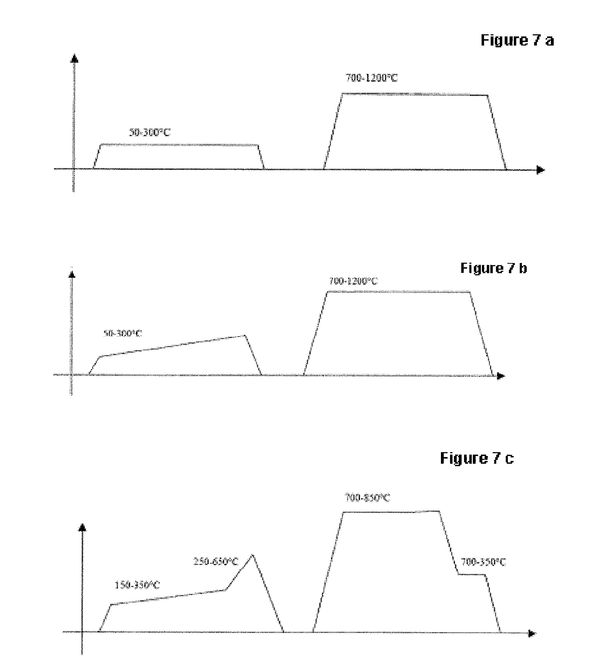

Suitable temperature profiles for the pre-hardening step in pre-drying zone 13 and the final heat treatment are shown in figures 7 a, 7 b and 7 c with the vertical axis indicating the temperature.
As shown in figure 7 a the temperature can be kept constant during the whole pre-drying and final heat treatment step.
As shown in figure 7 b and 7 c at least on of the temperature in the pre-drying step and the final heat treatment step can be varied over the heating time in different manners according to need and as is in principle generally known in the production of high temperature superconductor coated conductors.

For example in case of YBCO-123 a suitable temperature for converting the freshly deposited layer to the final oxide material is usually selected from about 700 to 850°C. If the temperature is higher, for example about 900°C, due to the high reactivity of YBCO reaction with the buffer layer has been observed. Further, oxygen diffusion through the buffer layer can take place leading to undesired oxidation of the metal substrate.

By the present invention double-sided coated conductors can be obtained with a superconductor layer and/or one or more buffer layers provided on both sides of the substrate of long length by a non-vacuum deposition technique, such as MOD, simultaneously and in continuous manner, wherein the simultaneously deposited layers are defect free and of equally high quality.

### reference numerals:

- 1: solution container
- 2: furnace
- 3: pay-out roller
- 4: substrate tape
- 5,6: guide roller
- 7: take-up roller
- 8: coating nozzle
- 9: slit
- 10: lower slit part

- 11: upper slit part
- 12: supply pipe
- 13: pre-drying zone
- 14: guide roller downstream to pre-drying zone
- 15: substrate
- 16: first buffer layer
- 17: superconductor layer
- 18: second buffer layer

## Claims

1. Dip-coating unit for simultaneous double-sided coating of a substrate of long length in continuous manner which comprises a coating container (1), a furnace (2), at least one supply means (3) for delivering the substrate of long length (4), at least one pulling means (7) for pulling the substrate of long length (4) continuously through the solution container (1) and the furnace (2), and optionally a pre-drying zone (13) provided between the solution container (1) and the furnace (2) for pre-drying the freshly deposited layer on the substrate of long length (4), wherein the furnace (2) or, if a pre-drying zone (13) is provided, at least the pre-drying zone is arranged in vertical set-up relative to the container (1).

2. Dip-coating unit according to claim 1,
wherein the dip-coating unit comprises a pre-drying zone provided between the solution container (1) and the furnace (2) for pre-drying the freshly deposited layer on the substrate of long length (4).

3. Dip-coating unit according to any of claims 1 or 2,
wherein at least the solution container (1) is closed towards its environment.

4. Dip-coating unit according to claim 3,
wherein the solution container is designed as closed tank.

5. Dip-coating unit according to claim 3,
wherein the solution container is housed in a closed container.

6. Dip-coating unit according to any of the preceding claims,
wherein each of the solution container (1), the pre-drying zone and the furnace (2) are closed towards each other.

7. Dip-coating unit according to any of the preceding claims,
wherein the solution container (1) is designed as a coating nozzle (8),
wherein the coating nozzle comprises a vertical slit (9) in its interior for passing the substrate of long length (4),
wherein the slit (9) extends from the bottom to the top of the coating nozzle (8) and is composed of at least two slit parts of different width arranged one after the other in vertical manner with a lower slit part (10) having a width for just allowing the substrate of long length (4) to be passed through and an upper slit part (11) with a larger width than the width of the lower slit part (10) for the coating solution.

8. Dip-coating unit according to claim 7,
wherein the upper slit part (11) is connected to a supply pipe (12) for supplying coating solution to the upper slit part (11).

9. Dip-coating unit according to any of the claims 7 or 8,
wherein the surface of the lower slit part (10) is made of a material of low surface energy in order to prevent leakage of the coating solution.

10. Coated conductor comprising a substrate of long length provided on both sides with at least one layer wherein said at least one layer on each side are obtainable by simultaneous deposition of a coating solution, wherein said at least one layer deposited simultaneously on each side is at least one selected from one or more buffer layers and a high temperature superconductor layer.

11. Coated conductor according to claim 10,
wherein the substrate is textured.

12. Coated conductor according to any of claims 10 or 11,
wherein the high temperature superconductor layers on both sides are of YBCO-type.

13. Process for the preparation of a double-sided coated conductor,
wherein a substrate of long length (4) is simultaneously coated on both sides with at least one layer by passing through a coating solution comprising a precursor material for the layer to be formed and forwarding the freshly coated substrate of long length to a furnace for converting the fresh coating to the final material,
wherein the freshly coated substrate of long length (4) is passed in vertical set-up at least until the freshly deposited layers on both sides are pre-hardened.

14. Process according to claim 13,
wherein the precursor material is selected from metal organic compounds.

15. Process according to claim 14,
wherein the precursor material is selected from metal trifluoroacetates.
